# EUROPÄISCHE PATENTSCHRIFT

(11) **EP 1 089 086 B1**
(45) Veröffentlichungstag und Bekanntmachung des Hinweises auf die Patenterteilung: **28.12.2005**
(21) Anmeldenummer: 00120822.2
(22) Anmeldetag: 23.09.2000
(51) Int. Cl.: G01R 33/30

(54) **Verbindungskonzept zwischen Kryokühlsystemen und gekühlten NMR-Probenköpfen**
Concept of connecting cryocooling sytems to NMR probe heads
Concept de raccord entre sytèmes de refroidissement cryogéniques et têtes de mesure RMN

(30) Priorität: 28.09.1999 DE 19946371
(43) Veröffentlichungstag der Anmeldung: 04.04.2001
(73) Patentinhaber: Bruker BioSpin AG, 8117 Fällanden (CH)
(72) Erfinder: Marek, Daniel, Dr. nat. sci., 5103 Möriken (CH); Triebe, René, Dipl. Masch. Ing., 8051 Zürich (CH)
(74) Vertreter: Kohler Schmid Möbus

(56) Entgegenhaltungen:
- US-A- 5 508 613
- US-A- 5 829 791
- US-A- 5 889 456

## Beschreibung

Die Erfindung betrifft eine Meßvorrichtung für Kernspinresonanz(NMR)-Messungen mit einem NMR-Probenkopf, der einen gekühlten NMR-Empfangsresonator zur Aufnahme von NMR-Meßsignalen enthält und über mindestens eine Transferleitung mit einer oder mehreren Kühlvorrichtungen zur Beschickung zweier Kühlkreisläufe mit Kühlmittel auf zwei unterschiedlichen kryogenen Temperaturniveaus verbunden ist, wobei jede Transferleitung mindestens eine Kühlzuleitung zum Transport von Kühlmittel auf einem der beiden Temperaturniveaus von den Kühlvorrichtungen zum NMR-Probenkopf und/oder eine Kühlrückleitung zum Rücktransport des Kühlmittels vom NMR-Probenkopf zu den Kühlvorrichtungen aufweist, wobei die mindestens eine Transferleitung vier Kühlleitungen, nämlich zwei Kühlzuleitungen und zwei Kühlrückleitungen umfasst.

Eine NMR-Meßvorrichtung der eingangs genannten Art ist beispielsweise bekannt aus der US 5,889,456-A.

Gekühlte NMR-Probenköpfe (= CRP = Cryogenic Probe) gehören zu einem neu aufkommenden Gebiet der NMR-Instrumentierung, das sehr interessante Zukunftsaussichten besitzt. Solche CRP's besitzen Empfangsresonatoren, die auf möglichst tiefe Temperaturen abgekühlt werden und entweder aus normalleitenden oder supraleitenden Materialien aufgebaut sind. Dies führt zu einer signifikanten Verbesserung des Signal-zu-Rausch-Abstandes und damit der NMR-Empfindlichkeit.

NMR-Empfangsresonatoren in den obengenannten CRP's können auch aus mehreren Hochfrequenz-Empfangsspulen oder Spulensätzen aufgebaut sein.

Außer dem Empfangsresonator können auch noch weitere Bestandteile des Detektionssystems gekühlt werden, wie z.B. die Verbindungskomponenten zwischen dem Resonator und dem Vorverstärker und der Vorverstärker selbst. Das führt im Allgemeinen zu einer weiteren Verbesserung der NMR-Empfindlichkeit.

Das Gebiet der CRP's ist noch relativ jung und vieles steckt noch in den Anfängen. Beschreibungen von CRP's findet man beispielsweise in der WO 96/39636 oder der US 5,585,723-A, und über Kühleinrichtungen dazu in der US 5,508,613-A sowie in der eingangs zitierten US 5,889,456-A. Die Kühleinrichtungen und die CRP's werden über Transferleitungen mit einer, zwei oder vier Verbindungsleitungen miteinander verbunden, wobei diese Leitungen vorzugsweise steckbar sind, wie etwa in der US 5,829,791-A beschrieben ist.

Die Kühlung der CRP's funktioniert so, daß ein bis zwei Kühlkreisläufe A und B auf der einen Seite durch eine Kühlquelle abgekühlt werden, auf der anderen Seite ihr Kühlvermögen an den zu kühlenden CRP abgeben.

Diese Kühlkreisläufe sind Leitungssysteme, in denen abgekühltes Heliumgas fließt. Der Kühlkreislauf braucht nicht unbedingt in sich geschlossen zu sein, er kann auch offen sein. Einen offenen Kühlkreislauf erhält man beispielsweise dann, wenn als Kühlquelle ein Dewarbehälter mit flüssigem Helium verwendet wird, und das gekühlte Heliumgas nach dem Kühlvorgang wieder ins Freie abgelassen wird. Ein erster offener Kühlkreislauf A kann aber auch mit einem zweiten, ebenfalls offenen Kühlkreislauf B verbunden werden, und auf diese Weise zu einem geschlossenen Kühlkreislauf werden.

Der erste Kühlkreislauf A auf der tiefsten Temperatur (0 bis 70K, vorzugsweise 4 bis 30K) ist immer notwendig und dient hauptsächlich der Kühlung des NMR-Resonators. Dieser Kühlkreislauf kann aber zusätzlich noch zur ganzen oder teilweisen Kühlung des Vorverstärkers sowie diverser elektrischer und mechanischer Komponenten im NMR-Probenkopf zwischen dem Resonator und dem Vorverstärker verwendet werden, z.B. Koppelnetzwerke, Filter, Zuleitungen, respektive Befestigungselemente, Strahlungsschilde, etc..

Ein zweiter Kühlkreislauf B ist meist erwünscht aber nicht zwingend erforderlich. Dieser arbeitet auf einer höheren Temperatur (z.B. 70K) und dient hauptsächlich der ganzen oder teilweisen Kühlung des Vorverstärkers. Er kann zudem auch oder ausschließlich nur zur Kühlung von elektrischen und mechanischen Komponenten (z.B. von elektrischen Filtern, HF- und anderen elektrischen Leitungen, mechanischen Strukturelementen, Strahlungsschilden, etc) benutzt werden.

Als Kühlmedium für die Kühlkreisläufe wird vorzugsweise Heliumgas verwendet. Zur Kühlung der Kühlkreisläufe werden verschiedene Kühlquellen herangezogen, nämlich Dewar-Behälter mit flüssigem Helium sowie einstufige oder zweistufige Kryokühler.

Die CRP's besitzen einen gekühlten Empfangsresonator und sind entweder ohne, oder mit einem oder mehreren gekühlten Vorverstärkern ausgerüstet. Die Empfangsresonatoren sind aus passiven Elementen zusammengesetzt und werden vorzugsweise auf Temperaturen im Bereich von 0 bis 30K gekühlt. Je nach der verwendeten Technologie bei den Vorverstärkern ist darauf zu achten, daß diese nicht zu stark abgekühlt werden, da sonst einige elektrische Komponenten, wie z.B. gewisse Halbleiterelemente, nicht mehr optimal arbeiten können. Temperaturen zwischen 70K und 80K werden in diesem Fall bevorzugt.

Abschließend läßt sich sagen, daß der Stand der Technik eine Vielfalt von Kühleinrichtungen und eine Vielfalt von unterschiedlich strukturierten CRP's kennt, die über eine oder mehrere Transferleitungen auf verschiedene Arten miteinander verbunden werden, ein bis zwei Kühlkreisläufe besitzen, wobei die einzelnen Teileinheiten von Fall zu Fall individuell aufeinander angepaßt werden müssen.

Aufgabe der vorliegenden Erfindung ist es demgegenüber, eine Meßvorrichtung der eingangs genannten Art, einen NMR-Probenkopf mit gekühltem NMR-Empfangsresonator, eine Transferleitung zum Einsatz in der Meßvorrichtung sowie eine Kühlanlage mit entsprechender Kühlvorrichtung mit möglichst einfachen und unaufwendigen Mitteln so zu modifizieren, daß völlig unterschiedliche CRP's mit beliebig aufgebauten Kühleinrichtungen ohne jegliche Anpassung mit dem kleinsten denkbaren Zeitaufwand miteinander gekoppelt werden können.

Erfindungsgemäß wird diese Aufgabe dadurch gelöst, dass die mindestens eine Transferleitung über steckbare Kryokupplungsvorrichtungen mit dem NMR-Probenkopf verbindbar ist, und dass
a) die Messvorrichtung nur eine einstufige Kühlvorrichtung mit einer einzigen Kühlquelle aufweist, aus welcher Kühlmittel über einen Anschluß in eine erste Kühlzuleitung eines ersten Kühlkreislaufs eingeleitet werden kann, und ein Anschluß für eine erste Kühlrückleitung des ersten Kühlkreislaufs über ein Kurzschlußstück mit einem Anschluß für eine erste Kühlzuleitung des zweiten Kühlkreislaufs verbunden ist
   und/oder
b) der NMR-Probenkopf zwei zweite Kühlzuleitungen und zwei zweite Kühlrückleitungen aufweist, wobei im NMR-Probenkopf eine Kurzschlußverbindung vorgesehen ist, mit der eine zweite Kühlzuleitung eines Kühlkreislaufs mit einer zweiten Kühlrückleitung desselben Kühlkreislaufs kurzgeschlossen ist.

Auf diese Weise können mittels einer einzigen Kühlquelle zwei Kühlkreisläufe auf unterschiedlichen Temperaturniveaus mit denkbar geringem Aufwand dargestellt und/oder mit einfachsten Mitteln die erfindungsgemäß vorgesehenen zwei Kühlkreisläufe aufrechterhalten werden.

Vorzugsweise ist nur eine einzige Transferleitung vorgesehen, die als Vierfach-Transferleitung aufgebaut ist und jeweils eine Kühlzuleitung und jeweils eine Kühlrückleitung für jeden der beiden Kühlkreisläufe umfaßt.

Besonders bevorzugt ist eine Ausführungsform der erfindungsgemäßen Meßvorrichtung, bei der eine oder mehrere Transferleitungen über ein Verbindungsstück starr mit einer der Kühlvorrichtung verbunden sind und zusammen mit dieser eine Kühlanlage bildet, die an einen NMR-Probenkopf mittels der standardisierten Kupplungsvorrichtungen anschließbar ist. Während bisher jeweils drei verschiedene Gruppen von Teileinheiten in einer gattungsgemäßen gekühlten Meßvorrichtung gehandhabt wurden, nämlich als erste Gruppe die Kühlsysteme mit den Kühlvorrichtungen, als zweite Gruppe die verschiedenen gekühlten NMR-Probenköpfe und als dritte Gruppe die Transferleitungen zur Verbindung der Kühlsysteme mit den NMR-Probenköpfen, wobei die entsprechenden Schnittstellen zwischen den drei Gruppen von Teileinheiten auf vielfältige Weise gestaltet und jeweils individuell von Fall zu Fall aufeinander angepaßt werden mußten, wird durch die obige Ausführungsform der Erfindung die erste und die dritte Gruppe von Teileinheiten zu einer einzigen Gruppe von Kühlanlagen mit genormtem Standardanschluß zusammengefaßt, der ohne weitere Anpassung an den erfindungsgemäß vorgesehenen Standard-Kühlanschluß irgendeines Mitglieds der dritten Gruppe von unterschiedlich gestalteten NMR-Probenköpfen in kürzester Zeit angekoppelt werden kann.

Bei einer Weiterbildung der obengenannten Ausführungsform ist das Verbindungsstück der Transferleitung mit der Kühlvorrichtung verschweißt oder verlötet, bei alternativen Ausführungsformen über einen Flansch verschraubt, so daß jeweils die Kühlanlage als einstückiges Teil aus dem Kühlsystem und der Transferleitung vorliegt.

Eine andere Weiterbildung sieht vor, daß das Verbindungsstück mit der Kühlvorrichtung lösbar, vorzugsweise steckbar verbunden ist, so daß die beiden Teileinheiten "Kühlvorrichtung" und "Transferleitung" im Bedarfsfalle, beispielsweise bei notwendig werdenden Reparaturen, getrennt behandelt werden können und beispielsweise schadhafte Einheiten durch andere entsprechend genormte Standardeinheiten problemlos ausgetauscht werden können.

Besonders bevorzugt ist eine Ausführungsform der erfindungsgemäßen Meßvorrichtung, bei der die Kryokupplungsvorrichtungen steckbare Kupplungen sind. Auf diese Weise wird das Handling der erfindungsgemäßen Meßvorrichtung besonders einfach und zeitsparend gestaltet und Umbauten oder Anbauten oder Anschlußmaßnahmen können auch von weniger qualifiziertem Personal durchgeführt werden. Hier macht sich auch der besondere Vorzug der Erfindung bemerkbar, der in einer Standardisierung der meßkopf-seitigen und transferleitungs-seitigen Kryokupplungsvorrichtungen liegt, die ohne weitere Anpassungen bei jeder beliebigen Konfiguration von Probenkopf und Kühlsystem stets miteinander verbunden werden können.

Bevorzugt ist auch eine Ausführungsform der Erfindung, bei der die Kryokupplungsvorrichtungen Vierfachkupplungen sind. Wie schon oben erwähnt, ist es bei bekannten gattungsgemäßen Meßvorrichtungen von Vorteil, wenn neben den NMR-Empfangsresonatoren auch andere elektronische Bauteile des Probenkopfes gekühlt werden können, wobei andererseits im Kühlsystem vorteilhafterweise zwei verschiedene Temperaturniveaus bereitgestellt werden. Die optimale Variante umfaßt daher jeweils zwei Kühlzuleitungen und zwei Kühlrückzuleitungen, um die beiden Temperaturkreisläufe auf unterschiedlichem kryogenem Temperaturniveau aufrechterhalten zu können. Die kompakteste Möglichkeit der Gestaltung der erfindungsgemäß eingesetzten Kryokupplungsvorrichtungen besteht daher in Vierfachkupplungen.

Alternativ sind aber auch viele andere Varianten der Gestaltung der Kryokupplungsvorrichtungen denkbar, von denen wiederum der Aufbau aus vier Einfachkupplungen die größte Flexibilität in der Handhabung erlaubt.

Eine weitere vorteilhafte Ausführungsform der Erfindung zeichnet sich dadurch aus, daß in der Kühlvorrichtung eine Reguliereinrichtung zur Beeinflussung der Kühlmittelströme in den Kühlkreisläufen vorgesehen ist. Damit können unterschiedliche Betriebszustände in den Kühlkreisläufen je nach momentaner Anforderung der Meßeinrichtung angesteuert bzw. eingestellt werden.

Bei einer bevorzugten Weiterbildung dieser Ausführungsform ist zwischen der Kühlzuleitung und der Kühlrückleitung des zweiten Kühlkreislaufs ein Bypass-Ventil vorgesehen. Mit diesem läßt sich die Menge des Kühlfluids, die via Transferleitung zum CRP geleitet wird, so reduzieren, daß z.B. der zu kühlende Vorverstärker oder andere elektronische Teile im NMR-Meßkopf ungefähr auf die gewünschte Temperatur, in der Regel ca. 70 K, abgekühlt werden.

Eine andere vorteilhafte Weiterbildung sieht in oder an den Kühlzuleitungen einen oder mehrere Heizer vor, mit denen eine Feinregulierung der jeweiligen Temperatur des Kühlkreislaufs erfolgen kann.

Besonders vorteilhaft ist auch eine Weiterbildung, bei der die Reguliereinrichtung am kühlvorrichtungsseitigen Ende der Transferleitung angeordnet ist, so daß sie kompakt innerhalb der Kühlvorrichtung als Anschlußbereich zur Transferleitung untergebracht werden kann. Zur Einsparung von Produktionskosten ist es günstig, wenn die Reguliereinrichtung für unterschiedlich aufgebaute Kühlvorrichtungen, insbesondere für ein- oder mehrstufige Kühlvorrichtungen jeweils identisch aufgebaut ist.

Eine besonders bevorzugte Ausführungsform der erfindungsgemäßen Vorrichtung zeichnet sich dadurch aus, daß der NMR-Probenkopf außer dem gekühlten NMR-Empfangsresonator noch weitere gekühlte Elektronikeinrichtungen, insbesondere einen gekühlten Vorverstärker enthält. Dadurch wird die erfindungsgemäß vorgesehene Vierfach-Transferleitung optimal ausgenutzt.

Vorzugsweise wird der NMR-Empfangsresonator über den ersten Kühlkreislauf A mit Kühlmittel auf einem besonders niedrigem Temperaturniveau versorgt, während ein großer Teil der übrigen Elektronik über den zweiten Kühlkreislauf auf einem höheren, aber immer noch kryogenen Temperaturniveau gekühlt wird.

Bei einer alternativen Ausführungsform ist der NMR-Probenkopf so aufgebaut, daß er lediglich einen Kühlkreislauf benötigt, insbesondere, daß er außer dem gekühlten NMR-Empfangsresonator keine weiteren gekühlten Elektronikeinrichtungen enthält. Auch hier ist die Anwendung des erfindungsgemäß standardisierten Kryokupplungssystems zur anpassungsfreien und problemlosen Ankopplung an irgendein vorhandenes Kühlsystem von großem Vorteil.

Bei einer weiteren besonders bevorzugten Ausführungsform weist die Kühlvorrichtung einen zweistufigen Kryokühler mit einem ersten Wärmetauscher für den ersten Kühlkreislauf und mit einem zweiten Wärmetauscher für den zweiten Kühlkreislauf auf. Dadurch können die erfindungsgemäß geforderten zwei unterschiedlichen kryogenen Temperaturniveaus für die beiden Kühlkreisläufe problemlos bereitgestellt werden.

Besonders unaufwendig und preisgünstig ist eine Weiterbildung dieser Ausführungsform, bei der vorgesehen ist, daß die Kühlquelle der Kühlvorrichtung aus einer Kühlmittelzuleitung besteht, über die aus einem Dewar-Behälter, beispielsweise durch Überdruckerzeugung mittels einer in den Behälter mündenden Druckleitung Kühlmittelfluid, insbesondere Helium, entnommen werden kann, und daß das erwärmte Kühlmittelfluid aus der Kühlrückleitung des zweiten Kühlkreislaufs vorzugsweise über einen Abfluß aus der Kühlvorrichtung entfernt werden kann. Allerdings bedingt der recht einfache, offene Aufbau des Kühlsystems einen erhöhten Verbrauch an Kühlmittelfluid, in der Regel relativ teures Helium.

Eine ebenfalls kostengünstige Weiterbildung sieht vor, daß die Kühlquelle der Kühlvorrichtung aus einem Wärmetauscher eines einstufigen Kryokühlers besteht, aus welchem Kühlmittelfluid, insbesondere Helium, entnommen und in die Kühlzuleitung des ersten Kühlkreislaufs eingeleitet, und in welchen das erwärmte Kühlmittelfluid aus der Kühlrückleitung des zweiten Kühlkreislaufs wieder rückgeleitet werden kann. So wird aus zwei "halboffenen" Kühlkreisläufen insgesamt ein geschlossenes Kühlsystem dargestellt.

Vorteilhaft ist auch ein NMR-Probenkopf mit gekühltem NMR-Empfangsresonator zum Einsatz in einer erfindungsgemäßen Meßvorrichtung gekennzeichnet durch eine standardisierte Kryokupplungsvorrichtung, in welche Kühlzuleitungen und Kühlrückleitungen für zwei Kühlkreisläufe auf unterschiedlichen kryogenen Temperaturniveaus im NMR-Probenkopf münden, und welche an eine dazu passende, ebenfalls standardisierte Kryokupplungsvorrichtung einer oder mehrerer Transferleitungen zu einer Kühlvorrichtung andocken kann, in die entsprechende Kühlzuleitungen und Kühlrückleitungen für die beiden Kühlkreisläufe in der Kühlvorrichtung münden.

Weiter vorteilhaft ist auch eine Transferleitung zum Einsatz in einer erfindungsgemäßen Meßvorrichtung für die Verbindung eines NMR-Probenkopfes der oben beschriebenen Art mit einer Kühlvorrichtung zur Beschickung zweier Kühlkreisläufe mit Kühlmittel auf zwei unterschiedlichen kryogenen Temperaturniveaus, die sich dadurch auszeichnet, daß die Transferleitung als Vierfach-Transferleitung aufgebaut ist und jeweils eine Kühlzuleitung und jeweils eine Kühlrückleitung für jeden der beiden Kühlkreisläufe umfaßt, und daß die Kühlzuleitungen und die Kühlrückleitungen der Transferleitung probenkopfseitig in eine standardisierte Kryokupplungsvorrichtung münden, die an eine dazu passende, ebenfalls standardisierte Kryokupplungsvorrichtung andocken kann, in welche entsprechende Kühlzuleitungen und Kühlrückleitungen für die beiden Kühlkreisläufe im NMR-Probenkopf münden.

Schließlich kann auch eine Kühlanlage mit einer einzigen Kühlvorrichtung zur Beschickung zweier Kühlkreisläufe mit Kühlmittel auf zwei unterschiedlichen kryogenen Temperaturniveaus vorteilhaft sein, wobei die Kühlvorrichtung über ein Verbindungsstück starr mit der Transferleitung der oben beschriebenen Art verbunden ist.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

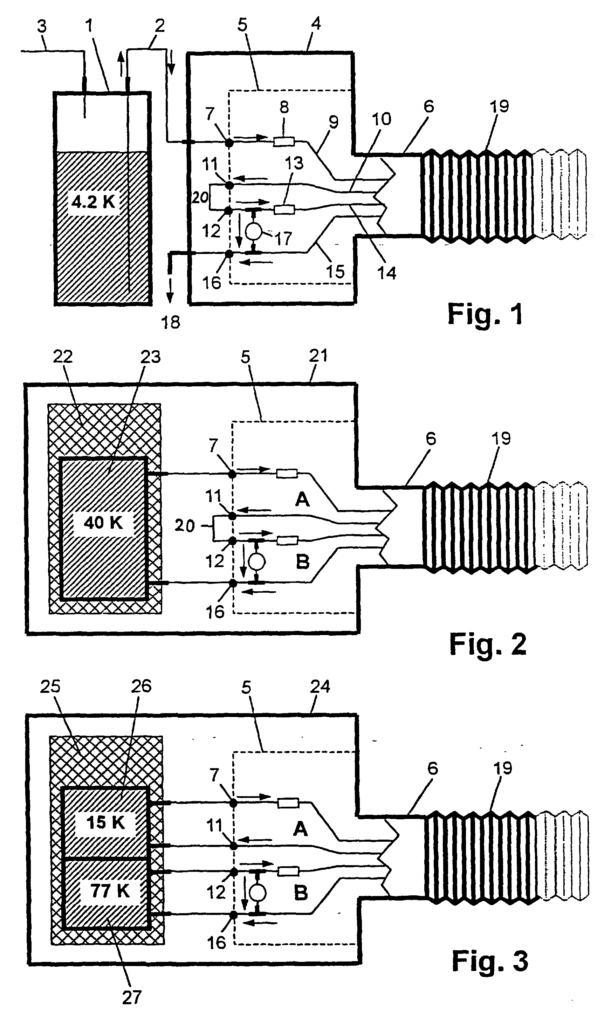

- Fig. 1: einen schematischen Vertikalschnitt durch ein offenes Kühlsystem mit einer einstufigen Kühlvorrichtung, die ein Helium-Dewargefäß als einzige Kühlquelle benutzt und in eine erfindungsgemäß modifizierte Vierfach-Transferleitung mündet;
- Fig. 2: einen Vertikalschnitt durch ein geschlossenes Kühlsystem mit einstufigem Kryokühler;
- Fig. 3: ein geschlossenes Kühlsystem mit einem zweistufigen Kryokühler;

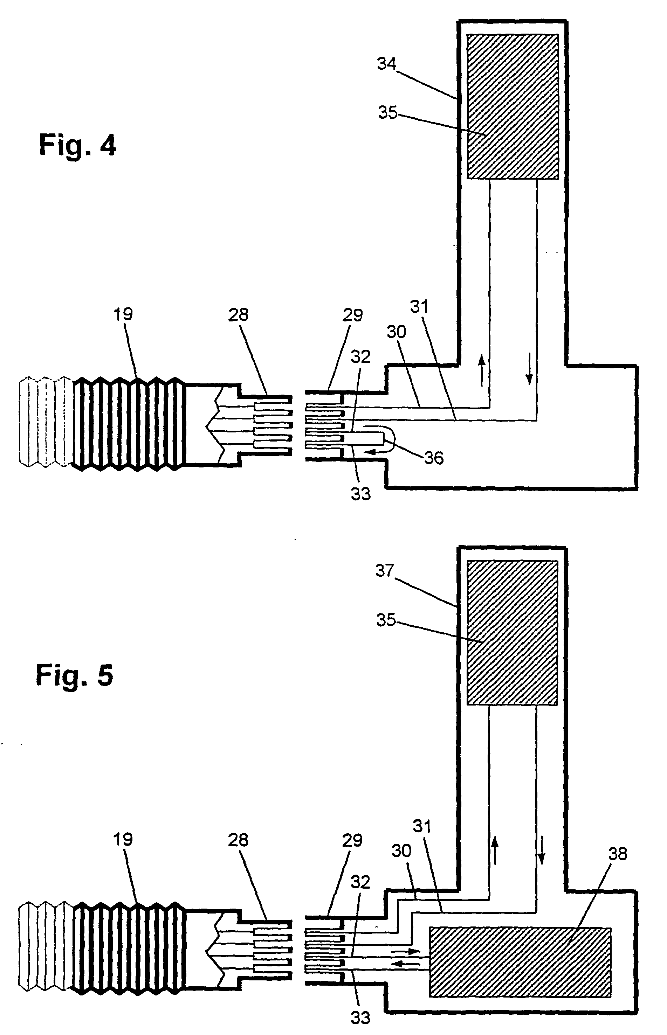

- Fig. 4: einen schematischen Vertikalschnitt durch einen NMR-Probenkopf mit gekühltem NMR-Empfangsresonator und erfindungsgemäß standardisierter Kryokupplungsvorrichtung sowie entsprechender Transferleitung mit dazu passender standardisierter Kryokupplungsvorrichtung; und
- Fig. 5: wie Fig. 4, aber mit weiteren gekühlten Bauelementen außer dem Empfangsresonator im NMR-Probenkopf.

Die Grundidee der vorliegenden Erfindung besteht darin, die diversen Kühlanlagen, die aus den Kühlvorrichtungen 4, 21, 24 und den Verbindungsvorrichtungen 19 aufgebaut sind, sowie die diversen CRP's 34, 37 so zu konstruieren, daß eine beliebige Kühlanlage mit einem beliebigen CRP verbunden werden kann, ohne daß Modifikationen an den einzelnen Elementen erforderlich sind. Mit anderen Worten, löst die erfinderische Idee ein komplexes ***Kompatibilitätsproblem***. Dies kann punktweise wie folgt beschrieben werden:
1. Die Kupplungselemente 28, 29 zwischen den Transferleitungen und den CRP's sollen stets ***zwei Kühlkreisläufe*** auf verschiedenen Temperaturen aufrecht erhalten, d.h. mit total vier Leitungen ausgestattet sein. Diese Leitungen können vorzugsweise in einer einzigen ***Transferleitung*** mit vier internen Leitungen zusammengefaßt, oder ***mit einem Satz von verschiedenen Transferleitungen*** mit je einer, zwei oder drei internen Leitungen aufgebaut sein. An den Enden der Transferleitungen, die zum CRP 34, 37 führen, sind ***steckbare Kupplungen*** 28 angebracht, um einen möglichst einfachen und schnellen Verbindungsvorgang zu ermöglichen. Je nach Art der Transferleitung werden dazu ***Einfach-***, ***Zweifach-***, ***Dreifach*** oder ***Vierfachkupplungen*** benutzt. Das andere Ende der Transferleitungen ist über das Verbindungsstück 6 mit den Kühlvorrichtungen 4, 21, 24 entweder fix (z.B. verschweißt oder mit einem Flansch verschraubt) oder steckbar verbunden.
2. ***Alle Kühlvorrichtungen 4, 21, 24 sollen Anschlußmöglichkeiten für zwei Kühlkreisläufe zur Verfügung stellen***. Bei einer Kühlvorrichtung 24 mit einem zweistufigen Kryokühler 25, sind zwei Kühlkreisläufe A und B auf zwei verschiedenen Temperaturen automatisch gegeben, und die genannte Forderung ist problemlos zu erfüllen. Hingegen bei den Kühlvorrichtungen 21 und 4, bei denen ein einstufigen Kryokühler 22 eingebaut ist respektive ein Dewar-Behälter 1 verwendet wird, steht normalerweise nur ein einziger Kühlkreislauf A zur Verfügung. Diese Kühlvorrichtungen werden nun derart modifiziert, daß der Kühlkreislauf A ganz oder teilweise in die Leitungen des Kühlkreislaufes B geführt wird und auf diese Weise ***den zweiten Kühlkreislauf B nach außen simuliert***. Dieser zweite Kühlkreislauf arbeitet zwar nicht autonom, da er mit dem ersten verbunden ist. Für den CRP ist dies jedoch bedeutungslos.
   Die Kryokühler 22, 25 sowie der Dewar-Behälter 1-sind mit Reguliervorrichtungen 5 verbunden, die auch identisch aufgebaut sein können, um damit einen produktionstechnischen Vorteil zu erreichen.
3. ***Alle CRP's sollen Anschlußmöglichkeiten für zwei Kühlkreisläufe besitzen***. Bei den CRP's, die bereits zwei Kühlkreisläufe A und B benötigen, ist diese Forderung selbstverständlich. Alle anderen hingegen, die nur den Kühlkreislauf A benötigen, würden mit zwei Anschlußleitungen auskommen. Diese CRP's werden nun derart modifiziert, daß die beiden überflüssigen Leitungen des Kreislaufes B ***im CRP direkt miteinander verbunden werden.*** Dadurch wird das ankommende Kühlmedium über diese Kurzschlußverbindung sofort wieder zurückgeleitet, so daß der Kühlkreislauf B aufrecht erhalten werden kann.

Diese drei Forderungen führen zu einem Bausystem von untereinander kompatiblen Kühlanlagen und CRP's. Die Kühlanlagen und CRP's werden über eine oder mehrere steckbare Kupplungen miteinander verbunden. Die steckbaren Kupplungen können erstens aus einer Vierfach-, zweitens aus einer Dreifach- und einer Einfach-, drittens aus zwei Zweifach-, viertens aus einer Zweifach- und zwei Einfach-, oder fünftens aus vier Einfachkupplungen zusammengesetzt sein. Wichtig ist, daß das definierte Bausystem durchwegs nur eine der fünf genannten Kupplungsarten benutzt, damit die Kompatibilät gewährleistet bleibt. Vorzuziehen ist die erste Variante mit der Vierfachkupplung, weil sie am elegantesten und benutzerfreundlichsten ist.

### Bezugszeichenliste:

- 1 =: Behälter mit flüssigem Helium
- 2 =: Zuleitung des kalten Heliums
- 3 =: Druckleitung zur Erzeugung eines Überdruckes im Behälter
- 4 =: Kühlvorrichtung, die als Kühlquelle einen mit flüssigem Helium gefüllten Dewar-Behälter 1 benutzt
- 5 =: Reguliereinrichtung
- 6 =: Verbindungsstück zwischen Kühlvorrichtung und Transferleitung
- 7 =: Anschluß der Zuleitung des Kühlkreislaufes A
- 8 =: Heizer für die Temperaturstabilisierung des Kühlkreislaufes A
- 9 =: Zuleitung des Kühlkreislaufes A
- 10 =: Rückleitung des Kühlkreislaufes A
- 11 =: Anschluß der Rückleitung des Kühlkreislaufes A
- 12 =: Anschluß der Zuleitung des Kühlkreislaufes B
- 13 =: Heizer für die Temperaturstabilisierung des Kühlkreislaufes B
- 14 =: Zuleitung des Kühlkreislaufes B
- 15 =: Rückleitung des Kühlkreislaufes B
- 16 =: Anschluß der Rückleitung des Kühlkreislaufes B
- 17 =: Bypass-Ventil für den Kühlkreislauf B
- 18 =: Abfluß des erwärmten Heliumgases nach dem Kühlvorgang
- 19 =: Vierfach-Transferleitung
- 20 =: Kurzschlußstück
- 21 =: Kühlvorrichtung mit einem einstufigen Kryokühler
- 22 =: Einstufiger Kryokühler
- 23 =: Wärmetauscher des einstufigen Kryokühlers
- 24 =: Kühlvorrichtung mit einem zweistufigen Kryokühler
- 25 =: Zweistufiger Kryokühler
- 26 =: Wärmetauscher der zweiten Stufe des zweistufigen Kryokühlers
- 27 =: Wärmetauscher der ersten Stufe des zweistufigen Kryokühlers
- 28 =: Vierfachkupplung der Transferleitung auf der Seite des CRP's
- 29 =: Vierfach-Kryokupplung des CRP's
- 30 =: Kühlzuleitung zum NMR-Empfangsresonator (Kühlkreislauf A)
- 31 =: Kühlrückleitung aus dem NMR-Empfangsresonator (Kühlkreislauf A)
- 32 =: Zuleitung des Kühlmediums beim Kühlkreislauf B
- 33 =: Rückleitung des Kühlmediums beim Kühlkreislauf B.
- 34 =: CRP, der nur einen Kühlkreislauf verwendet.
- 35 =: Empfangsresonator des CRP's
- 36 =: Kurzschlussverbindung des Kühlkreislaufes B, wenn der CRP nur einen Kühlkreislauf verwendet.
- 37 =: CRP, der beide Kühlkreisläufe A und B verwendet.
- 38 =: gekühlter Vorverstärker

## Patentansprüche

1. Meßvorrichtung für Kernspinresonanz(NMR)-Messungen mit einem NMR-Probenkopf (34, 37), der einen gekühlten NMR-Empfangsresonator (35) zur Aufnahme von NMR-Meßsignalen enthält und über mindestens eine Transferleitung mit einer oder mehreren Kühlvorrichtungen zur Beschickung zweier Kühlkreisläufe (A, B) mit Kühlmittel auf zwei unterschiedlichen kryogenen Temperaturniveaus verbunden ist, wobei jede Transferleitung mindestens eine Kühlzuleitung zum Transport von Kühlmittel auf einem der beiden Temperaturniveaus von den Kühlvorrichtungen zum NMR-Probenkopf und/oder eine Kühlrückleitung zum Rücktransport des Kühlmittels vom NMR-Probenkopf zu den Kühlvorrichtungen aufweist,
wobei die mindestens eine Transferleitung vier Kühlleitungen, nämlich zwei Kühlzuleitungen und zwei Kühlrückleitungen umfasst,
**dadurch gekennzeichnet,**
**dass** die mindestens eine Transferleitung über steckbare Kryokupplungsvorrichtungen (28, 29) mit dem NMR-Probenkopf (34, 37) verbindbar ist,
und **dass**
a) die Messvorrichtung nur eine einstufige Kühlvorrichtung (4, 21) mit einer einzigen Kühlquelle (2, 23) aufweist, aus welcher Kühlmittel über einen Anschluss (7) in eine erste Kühlzuleitung (9) eines ersten Kühlkreislaufs (A) eingeleitet werden kann, und ein Anschluss (11) für eine erste Kühlrückleitung (10) des ersten Kühlkreislaufs (A) über ein Kurzschlussstück (20) mit einem Anschluss (12) für eine erste Kühlzuleitung (14) des zweiten Kühlkreislaufs (B) verbunden ist,
und/oder
b) der NMR-Probenkopf zwei zweite Kühlzuleitungen und zwei zweite Kühlrückleitungen aufweist, wobei im NMR-Probenkopf eine Kurzschlussverbindung (36) vorgesehen ist, mit der eine zweite Kühlzuleitung (32) eines Kühlkreislaufs (B) mit einer zweiten Kühlrückleitung (33) desselben Kühlkreislaufs (B) kurzgeschlossen ist.

2. Vorrichtung nach Anspruch 1, **dadurch gekennzeichnet, daß** nur eine einzige Transferleitung (19) vorgesehen ist, die als Vierfach-Transferleitung aufgebaut ist und jeweils eine Kühlzuleitung (9, 14) und jeweils eine Kühlrückleitung (10, 15) für jeden der beiden Kühlkreisläufe (A, B) umfaßt, und daß die Transferleitung (19) über ein Verbindungsstück (6) starr mit der Kühlvorrichtung (4, 21, 24) verbunden ist und zusammen mit dieser eine Kühlanlage bildet, die an einen NMR-Probenkopf mittels der steckbaren Kupplungsvorrichtungen (28, 29) anschließbar ist.

3. Vorrichtung nach einem der vorhergehenden Ansprüche, **dadurch gekennzeichnet, daß** die Kryokupplungsvorrichtungen (28, 29) Vierfachkupplungen sind.

4. Vorrichtung nach einem der vorhergehenden Ansprüche, **dadurch gekennzeichnet, daß** in der Kühlvorrichtung (4, 21, 24) eine Reguliereinrichtung (5) zur Beeinflussung der Kühlmittelströme in den Kühlkreisläufen (A, B) vorgesehen ist, und daß zwischen der Kühlzuleitung (14) und der Kühlrückleitung (15) des zweiten Kühlkreislaufs (B) ein Bypass-Ventil (17) vorgesehen ist.

5. Vorrichtung nach Anspruch 4, **dadurch gekennzeichnet, daß** die Reguliereinrichtung (5) am kühlvorrichtungsseitigen Ende der Transferleitung (19) angeordnet ist.

6. Vorrichtung nach einem der vorhergehenden Ansprüche, **dadurch gekennzeichnet, daß** der NMR-Probenkopf (34) so aufgebaut ist, daß er nur einen Kühlkreislauf (A) benötigt, insbesondere daß er außer dem gekühlten NMR-Empfangsresonator (35) keine weiteren gekühlten Elektronikeinrichtungen enthält.

7. Vorrichtung nach einem der vorhergehenden Ansprüche, **dadurch gekennzeichnet, daß** die Kühlvorrichtung (24) einen zweistufigen Kryokühler (25) mit einem ersten Wärmetauscher (26) für den ersten Kühlkreislauf (A) und mit einem zweiten Wärmetauscher (27) für den zweiten Kühlkreislauf (B) aufweist.

8. Vorrichtung nach einem der vorhergehenden Ansprüche, **dadurch gekennzeichnet, daß** die Kühlquelle der Kühlvorrichtung (4) aus einer Kühlmittelzuleitung (2) besteht, über die aus einem Dewar-Behälter (1), beispielsweise durch Überdruckerzeugung mittels einer in den Behälter (1) mündenden Druckleitung (3) Kühlmittelfluid, insbesondere Helium, entnommen werden kann, und daß das erwärmte Kühlmittelfluid aus der Kühlrückleitung (15) des zweiten Kühlkreislaufs (B) vorzugsweise über einen Abfluß (18) aus der Kühlvorrichtung (4) entfernt werden kann.

9. Vorrichtung nach einem der vorhergehenden Ansprüche, **dadurch gekennzeichnet, daß** die Kühlquelle der Kühlvorrichtung (21) aus einem Wärmetauscher (23) eines einstufigen Kryokühlers (22) besteht, aus welchem Kühlmittelfluid, insbesondere Helium, entnommen und in die Kühlzuleitung (9) des ersten Kühlkreislaufs (A) eingeleitet, und in welchen das erwärmte Kühlmittelfluid aus der Kühlrückleitung (15) des zweiten Kühlkreislaufs (B) wieder rückgeleitet werden kann.

## Claims

1. Measuring device for nuclear magnetic resonance (NMR) measurements comprising an NMR probe head (34, 37) containing a cooled NMR receiver resonator (35) for receiving NMR measuring signals and being connected via at least one transfer line to one or more cooling devices for supplying two coolant loops (A, B) with coolant at two different cryogenic temperature levels, wherein each transfer line comprises at least one coolant feed line for transporting coolant at one of the two temperature levels from the cooling devices to the NMR probe head, and/or one coolant return line for returning the coolant from the NMR probe head to the cooling devices, wherein the at least one transfer line comprises four cooling lines, namely two coolant feed lines and two coolant return lines, **characterized in that** the at least one transfer line can be connected to the NMR probe head (34, 37) via insertable cryo-coupling devices (28, 29) and **in that** the measuring device comprises only one single-stage cooling device (4, 21) with one single cooling source (2, 23) from which coolant can be introduced via the connection point (7) into a first coolant feed line (9) of a first coolant loop (A) and one connection point (11) for a first coolant return line (10) of the first coolant loop (A) is connected to a connection point (12) for a first coolant feed line (14) of the second coolant loop (B) via a short-circuit piece (20) and/or the NMR probe head comprises two second coolant feed lines and two second coolant return lines, wherein a short-circuit connection (36) is provided in the NMR probe head (34) for short-circuiting a second coolant feed line (32) of a coolant loop (8) to a second coolant return line (33) of the same coolant loop (B).

2. Device according to claim 1, **characterized in that** only one single transfer line (19) is provided which is designed as quadruple transfer line and comprises one coolant feed line (9, 14) and one coolant return line (10, 15) for each of the two coolant loops (A, B) and that the transfer line (19) is rigidly connected to the cooling device (4, 21, 24) via a connection piece (6) and forms with same a cooling system which can be connected to an NMR probe head by means of the insertable coupling devices (28, 29).

3. Device according to any one of the preceding claims, **characterized in that** the cryo-coupling devices (28, 29) are quadruple couplings.

4. Device according to any one of the preceding claims, **characterized in that** the cooling device (4, 21, 24) is provided with a regulation device (5) for influencing the coolant flows in the coolant loops (A, B), and **in that** a bypass valve (17) is provided between the coolant feed line (14) and the coolant return line (15) of the second coolant loop (B).

5. Device according to claim 4, **characterized in that** the regulation device (5) is mounted at the end of the transfer line (19) on the cooling device side.

6. Device according to any one of the preceding claims, **characterized in that** the NMR probe head (34) is designed such that it requires only one coolant loop (A), in particular that it does not contain any further cooled electronic means except for the cooled NMR receiver resonator (35).

7. Device according to any one of the preceding claims, **characterized in that** the cooling device (24) comprises a two-stage cryo-cooler (25) comprising a first heat exchanger (26) for the first coolant loop (A) and a second heat exchanger (27) for the second coolant loop (B).

8. Device according to any one of the preceding claims, **characterized in that** the cooling source of the cooling device (4) consists of a coolant feed line (2) from which coolant fluid, in particular helium, can be extracted from a Dewar container (1), e.g. by generating an overpressure using a pressure line (3) terminating in the container (1), and that the heated coolant fluid can be removed from the coolant return line (15) of the second coolant loop (B) of the cooling device (4) preferably via an outlet (18).

9. Device according to any one of the preceding claims, **characterized in that** the cooling source of the cooling device (21) consists of a heat exchanger (23) of a one-stage cryo-cooler (22) from which coolant fluid, in particular, helium, is taken and introduced into the coolant feed line (9) of the first coolant loop (A) and into which the heated coolant fluid can be returned from the coolant return line (15) of the second coolant loop (B).

## Revendications

1. Dispositif de mesure pour des mesures de résonance magnétique nucléaire (RMN) avec une tête de mesure RMN (34, 37) qui contient un résonateur de réception RMN refroidi (35) pour la réception de signaux de mesure RMN et est reliée par au moins une conduite de transfert à un ou plusieurs dispositifs de refroidissement pour l'alimentation de deux circuits de refroidissement (A, B) en réfrigérant à deux niveaux de température cryogéniques différents, chaque conduite de transfert présentant au moins une conduite d'amenée de réfrigérant pour le transport de réfrigérant à un des deux niveaux de température des dispositifs de refroidissement vers la tête de mesure RMN et/ou une conduite de retour de réfrigérant pour le transport inverse du réfrigérant de la tête de mesure RMN vers les dispositifs de refroidissement,
ladite au moins une conduite de transfert comprenant quatre conduites de réfrigérant, à savoir deux conduites d'amenée de réfrigérant et deux conduites de retour de réfrigérant,
**caractérisé par le fait**
**que** ladite au moins une conduite de transfert peut être raccordée à la tête de mesure RMN (34, 37) au moyen de dispositifs d'accouplement cryogéniques enfichables (28, 29),
et **que**
a) le dispositif de mesure ne présente qu'un seul dispositif de refroidissement à un étage (4, 21) avec une seule source de froid (2, 23), à partir duquel on peut envoyer du réfrigérant dans une première conduite d'amenée de réfrigérant (9) d'un premier circuit de refroidissement (A) et un raccord (11) pour une première conduite de retour de réfrigérant (10) du premier circuit de refroidissement (A) est relié par une pièce de court-circuit (20) à un raccord (12) pour une première conduite d'amenée de réfrigérant (14) du deuxième circuit de refroidissement (B),
et/ou
b) la tête de mesure RMN présente deux deuxièmes conduites d'amenée de réfrigérant et deux deuxièmes conduites de retour de réfrigérant, et il est prévu dans la tête de mesure RMN une liaison de court-circuit (36) qui permet de court-circuiter une deuxième conduite d'amenée de réfrigérant (32) d'un circuit de refroidissement (B) avec une deuxième conduite de retour de réfrigérant (33) du même circuit de refroidissement (B).

2. Dispositif selon la revendication 1, **caractérisé par le fait qu'**il est prévu une seule conduite de transfert (19) qui est constituée comme conduite de transfert quadruple et comprend chaque fois une conduite d'amenée de réfrigérant (9, 14) et une conduite de retour de réfrigérant (10, 15) pour chacun des deux circuits de refroidissement (A, B), et que la conduite de transfert (19) est reliée rigidement au dispositif de refroidissement (4, 21, 24) par une pièce de raccord (6) et forme avec celui-ci un système de refroidissement qui peut être raccordé à une tête de mesure RMN au moyen des dispositifs d'accouplement enfichables (28, 29).

3. Dispositif selon l'une des revendications précédentes, **caractérisé par le fait que** les dispositifs d'accouplement cryogéniques (28, 29) sont des accouplements quadruples.

4. Dispositif selon l'une des revendications précédentes, **caractérisé par le fait qu'**il est prévu dans le dispositif de refroidissement (4, 21, 24) un dispositif de régulation (5) pour influencer les courants de réfrigérant dans les circuits de refroidissement (A, B) et qu'il est prévu un clapet de dérivation (17) entre la conduite d'amenée de réfrigérant (14) et la conduite de retour de réfrigérant (15) du deuxième circuit de refroidissement (B).

5. Dispositif selon la revendication 4, **caractérisé par le fait que** le dispositif de régulation (5) est disposé à l'extrémité côté dispositif de refroidissement de la conduite de transfert (19).

6. Dispositif selon l'une des revendications précédentes, **caractérisé par le fait que** la tête de mesure RMN (34) est conçue de manière à ne nécessiter qu'un seul circuit de refroidissement (A), en particulier à ne contenir aucun autre dispositif électronique refroidi en dehors du résonateur de réception RMN refroidi (35).

7. Dispositif selon l'une des revendications précédentes, **caractérisé par le fait que** le dispositif de refroidissement (24) présente un cryorefroidisseur à deux étages (25) avec un premier échangeur de chaleur (26) pour le premier circuit de refroidissement (A) et avec un deuxième échangeur de chaleur (27) pour le deuxième circuit de refroidissement (B).

8. Dispositif selon l'une des revendications précédentes, **caractérisé par le fait que** la source de froid du dispositif de refroidissement (4) est constituée d'une conduite d'amenée de réfrigérant (2) par laquelle du fluide réfrigérant, en particulier de l'hélium, peut être prélevé d'un réservoir Dewar (1), par exemple par génération de surpression au moyen d'une conduite de refoulement aboutissant dans le réservoir (1), et que le fluide réfrigérant réchauffé provenant de la conduite de retour de réfrigérant (15) du deuxième circuit de refroidissement (B) peut être évacué du dispositif de refroidissement (4) de préférence par une sortie (18).

9. Dispositif selon l'une des revendications précédentes, **caractérisé par le fait que** la source de froid du dispositif de refroidissement (21) est constituée d'un échangeur de chaleur (23) d'un cryorefroidisseur à un étage (22) duquel du fluide réfrigérant, en particulier de l'hélium, est prélevé et envoyé dans la conduite d'amenée de réfrigérant (9) du premier circuit de refroidissement (A) et auquel le fluide réfrigérant réchauffé provenant de la conduite de retour de réfrigérant (15) du deuxième circuit de refroidissement (B) peut être ramené.
